# EUROPÄISCHE PATENTANMELDUNG

(11) **EP 1 480 268 A2**
(43) Veröffentlichungstag der Anmeldung: **24.11.2004**
(21) Anmeldenummer: 04000470.7
(22) Anmeldetag: 13.01.2004
(51) Int. Cl.: H01L 23/10, H05K 5/06

(54) **Gehäuse zur definierten Verfüllung**

(30) Priorität: 22.05.2003 DE 10323146
(71) Anmelder: ROBERT BOSCH GMBH, 70442 Stuttgart (DE)
(72) Erfinder: Stratmann, Andreas, 72810 Gomaringen (DE)

(57) **Zusammenfassung**

Die Erfindung beschreibt eine mikromechanische Vorrichtung bzw. ein Verfahren zur Herstellung dieser mikromechanischen Vorrichtung, bei der die Vorrichtung ein Gehäuse mit wenigstens einem ersten und einem zweiten Bereich aufweist. Dabei ist vorgesehen, dass der erste Bereich des Gehäuses wenigstens ein Bauelement besitzt. Dieses Bauelement kann dabei aus einer elektronischen, einer elektrischen und/oder einer mechanischen Komponente bestehen. Darüber hinaus ist vorgesehen, dass der erste Bereich mit einer Einfassung umgeben ist, die wenigstens teilweise mit einem Verfüllmaterial aufgefüllt ist. Der Kern der Erfindung besteht nun darin, dass der erste Bereich weitestgehend mit dem Verfüllmaterial aufgefüllt ist, die maximale Verfüllungshöhe des ersten Bereichs durch die Einfassung vorgegeben ist und nicht überschritten werden kann. Darüber hinaus ist vorgesehen, dass wenigstens ein Teil des Bauelements vom Verfüllungsmaterial bedeckt wird. Dabei kann vorgesehen sein, dass die Oberseite des Bauelements oder lediglich ein Teil der Seite des Bauelements mit dem Verfüllungsmaterial bedeckt ist. Dies kann beispielsweise bedeuten, dass das Bauelement über die Einfassung hinaus ragt oder eine Oberseite aufweist, die keine Bedeckung mit dem Verfüllungsmaterial zur Aufrechterhaltung der Funktionsweise erlaubt.

## Beschreibung

### Stand der Technik

Die Erfindung geht aus von einer mikromechanischen Vorrichtung bzw. von einem Verfahren zur Herstellung einer mikromechanischen Vorrichtung, bei der die Verfüllung wenigstens eines teils eines Gehäuses mit einer vordefinierten Verfüllungshöhe quasi selbstjustierend erfolgt.

Bei einer Vielzahl von Gehäusen, speziell im Bereich der Sensorik, werden die elektronischen Komponenten in einem Gehäuse montiert und anschließend verfüllt. Dabei dient die Verfüllung in der Regel der Passivierung der Komponenten bzw. dem Schutz der Komponente gegenüber Umwelteinflüssen (Wasser, Luft, Benzin, Salz, etc.). Weiterhin kann durch die Verfüllung eine Dämpfung beispielsweise gegenüber Vibrationen oder ähnlichem erreicht werden. Im Bereich der Sensorik mit mikromechanischen Sensorkomponenten stellt die zu vergießende Komponente neben der elektronischen Schaltung meist auch bewegliche Strukturen, wie z. B. eine Membran oder Schwingungskörper dar, deren Eigenschaften durch die Verfüllung verändert werden.

Bei der heutigen Verfüllung von Gehäusen mit zum Beispiel Gelen oder Passivierungsstoffen ist aufgrund der Eigenschaften der verwendeten Materialien, aber auch der unter wirtschaftlichen Gesichtspunkten zu erreichenden Genauigkeit, eine exakte Vorhersage der Verfüllmenge im Gehäuse nicht möglich ist. Somit kann auch eine Passivierungsanforderung, wie sie regelmäßig bei mikromechanischen Vorrichtungen gefordert wird, nicht sichergestellt werden.

### Vorteile der Erfindung

Die Erfindung beschreibt eine mikromechanische Vorrichtung bzw. ein Verfahren zur Herstellung dieser mikromechanischen Vorrichtung, bei der die Vorrichtung ein Gehäuse mit wenigstens einem ersten und einem zweiten Bereich aufweist. Dabei ist vorgesehen, dass der erste Bereich des Gehäuses wenigstens ein Bauelement besitzt. Dieses Bauelement kann dabei aus einer elektronischen, einer elektrischen und/oder einer mechanischen Komponente bestehen. Darüber hinaus ist vorgesehen, dass der erste Bereich mit einer Einfassung umgeben ist, die wenigstens teilweise mit einem Verfüllmaterial aufgefüllt ist. Der Kern der Erfindung besteht nun darin, dass der erste Bereich weitestgehend mit dem Verfüllmaterial aufgefüllt ist, die maximale Verfüllungshöhe des ersten Bereichs durch die Einfassung vorgegeben ist und nicht überschritten werden kann. Darüber hinaus ist vorgesehen, dass wenigstens ein Teil des Bauelements vom Verfüllungsmaterial bedeckt wird. Dabei kann vorgesehen sein, dass die Oberseite des Bauelements oder lediglich ein Teil der Seite des Bauelements mit dem Verfüllungsmaterial bedeckt ist. Dies kann beispielsweise bedeuten, dass das Bauelement über die Einfassung hinaus ragt oder eine Oberseite aufweist, die keine Bedeckung mit dem Verfüllungsmaterial zur Aufrechterhaltung der Funktionsweise erlaubt.

Wird der erste Bereich des Gehäuses teilweise bzw. bis zur maximalen Verfüllungshöhe mit dem Verfüllungsmaterial aufgefüllt, so kann vorgesehen sein, dass der zweite Bereich kein Verfüllungsmaterial aufweist oder wenigstens teilweise mit Verfüllungsmaterial aufgefüllt ist.

Vorteilhafterweise wird die Höhe der Einfassung des ersten Bereichs in Abhängigkeit von der Höhe bzw. der Größe des wenigstens einen Bauelements gewählt. Vorzugsweise wird dabei eine Höhe der Einfassung gewählt, die größer als die Höhe des Bauelements ist. Dies sichert bei einer Verfüllung des ersten Bereichs eine Bedeckung und somit eine Fixierung des Bauelements im erste Bereich.

In einer besonderen Ausgestaltung der Erfindung ist vorgesehen, dass das Bauelement durch das Verfüllungsmaterial vollkommen bedeckt ist. Durch die Höhe der Einfassung, bei gleichzeitiger Verfüllung des ersten Bereichs bis zur maximale Verfüllungshöhe, kann somit die Schichtdicke über dem Bauelement definiert vorgegeben werden.

Als Bauelement im ersten Bereich ist ein Halbleiterbauelement vorgesehen, wobei dieses Halbleiterbauelement erfindungsgemäß ein Sensorelement darstellt, wobei durchaus auch vorgesehen sein kann, dass mehrere Halbleiterbauelemente bzw. Sensorelemente im ersten Bereich angeordnet sein können. Mit diesem wenigstens einen Sensorelement kann die Aufnahme eines physikalischen und/oder chemischen Parameters vorgesehen sein. Eine Umwandlung dieses physikalischen und/oder chemischen Parameters in eine messtechnisch verwertbare Messgröße kann dabei durch eine entsprechende Auswerteschaltung innerhalb oder außerhalb des ersten Bereichs erfolgen. Gängige Halbleiterbauelemente, die entsprechende physikalische und/oder chemische Parameter aufnehmen können, können beispielsweise durch eine Membran, einen Schwingungskörper, einen Drehkörper, einen Widerstand, einen Temperaturfühler, eine spezielle Rezeptorenbeschichtung oder einen Dehnungsmessstreifen dargestellt werden. In einer besonderen Ausgestaltung der Erfindung kann jedoch vorgesehen sein, dass das Halbleiterbauelement keine sensierende Wirkung aufweist.

Bei den bisher beschriebenen Ausgestaltungen der Erfindung ist vorgesehen, dass die Verfüllung des ersten Bereichs bzw. die Bedeckung des Sensorelements mit dem Verfüllungsmaterial zu keiner Änderung der Eigenschaften des Sensorelements führt. Dieses ist insbesondere deshalb wünschenswert, da die Erfassung der Parameter durch das Sensorelement bei sensiblen Messwerterfassung durch die Verfüllung gestört werden kann. In einer Weiterbildung der Erfindung kann jedoch vorgesehen sein, dass die Bedeckung des Sensorelements mit dem Verfüllungsmaterial zu einer gewollten Funktionsänderung des Sensorelements führt. Dies kann bspw. dazu ausgenutzt werden, die Bedeckung derart zu wählen, dass ein erwünschter Effekte bei der Messwertaufnahme erzielt wird. Zu diesem Zweck kann vorgesehen sein, das Sensorelemente stellenweise unbedeckt zu lassen oder eine definierte Schichtdicke des Verfüllungsmaterials auf dem Sensorelement aufzubringen. Darüber hinaus kann auch eine Wahl des Verfüllungsmaterials oder eine Kombination aus verschiedenen Verfüllungsmaterialien den erwünschten Effekte erzielen.

Weitere Vorteile ergeben sich aus der nachfolgenden Beschreibung von Ausführungsbeispielen bzw. aus den abhängigen Patentansprüchen.

### Zeichnungen

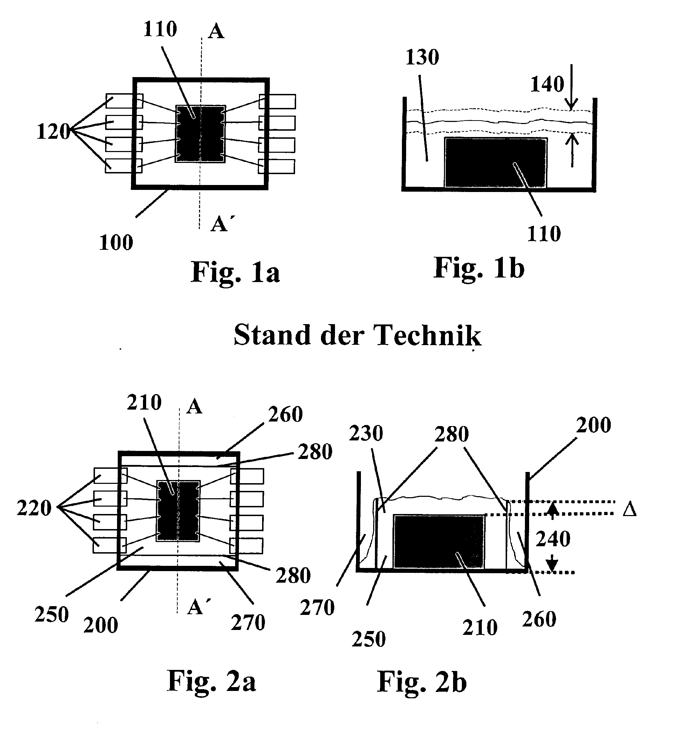

Mit den beiden Zeichnungen soll der Vorteil der vorliegenden Erfindung gegenüber dem Stand der Technik dargestellt werden. Dazu ist in Figur 1a bzw. 1b eine Verfüllung eines Gehäuses dargestellt, wie sie als Stand der Technik standardmäßig eingesetzt wird. Darüber hinaus zeigt Figur 2a und 2b eine Verfüllung eines Gehäuses, wie es nach der erfindungsgemäßen Methodik vorgesehen ist.

### Ausführungsbeispiel

In Figur 1a und 1b ist als ein mögliches Ausführungsbeispiel der vorliegenden Erfindung ein Gehäuse 100 dargestellt, wie es nach dem Stand der Technik mit einem Verfüllungsmaterial aufgefüllt wird. Neben der vollständigen Bedeckung des Sensorelement durch das Verfüllungsmaterial ist jedoch auch eine Bedeckung alleine der Seiten des Sensorelements denkbar, beispielsweise zur Fixierung. Als anschauliches Beispiel ist in Figur 1a jedoch die komplette Verfüllung eines typischen Gehäuses 100 dargestellt, in welchem ein Sensorelement 110 über Zuleitungen 120 angesteuert wird. Ein Querschnitt durch die Figur 1a entlang der Linie A'A ist in Figur 1b dargestellt. Zu erkennen ist bei diesem Querschnitt die Verfüllung des Gehäuses 100 mit einem Verfüllungsmaterial 130. Je nach Menge des eingefüllten Verfüllungsmaterials 130 kommt es zu einer gewissen Schwankungsbreite 140 der maximalen Verfüllung des Gehäuses. Um eine vollständige Bedeckung des Sensorelements 110 sicherzustellen, ist es deshalb notwendig, eine ausreichende Verfüllungsmenge des Verfüllungsmaterials 130 in das Gehäuse 100 einzubringen. Ungenauigkeiten bei der Verfüllung bzw. Einschlüsse von Luftblasen im Gehäuse 100 lassen eine Schwankungsbreite 140 des Verfüllungsmaterials 130 über dem Sensorelement 110 zu, die eine definierte Bedeckung des Sensorelements 110 erschweren, wenn nicht gar unmöglich machen.

Demgegenüber zeigt die Verfüllung gemäß der vorliegenden Erfindung in Figur 2a ein mikromechanisches Gehäuse 200, bei dem wenigstens zwei Bereiche im Gehäuse 200 voneinander unterschieden werden können. Wie beim Stand der Technik ist im vorliegenden Ausführungsbeispiel ein Gehäuse 200 vorgesehen, welches ein Sensorelement 210 aufweist, das durch Zuleitungen 220 angesteuert wird. Entgegen dem Stand der Technik in Figur 1a bzw. 1b ist das Gehäuse 200 jedoch durch Einfassungen 280 in wenigstens zwei Bereiche aufgeteilt. Ein erster Bereich 250 wird dabei durch denjenigen Bereich definiert, in dem sich das Sensorelement 210 befindet, wohingegen die restlichen Bereiche 260 bzw. 270 des Gehäuses 200 zu einem zweiten Bereich zusammengefasst werden. Zur Verdeutlichung der beiden Bereiche ist ebenfalls wie in Figur 1 ein Querschnitt durch das Gehäuse 200 entlang der Linie A'A in Figur 2b dargestellt. Zu erkennen ist dabei der erste Bereich 250 und der aus den beiden Teilbereichen 260 und 270 bestehende zweite Bereich. Aus Symmetriegründen wurde bei dem vorliegenden Ausführungsbeispiel in Figur 2a und 2b der zweite Bereich in zwei Teilbereiche 260 und 270 aufgeteilt. In anderen Ausführungsbeispielen kann jedoch auch vorgesehen sein, die beiden Teilbereiche zu verbinden oder weiter zu unterteilen.

Durch die Unterteilung des Gehäuses 200 kann gezielt der erste Bereich 250 mit dem Sensorelement 210 mit einem Verfüllungsmaterial 230 aufgefüllt werden. Die maximale Verfüllungshöhe 240 wird dabei durch die Höhe der Einfassungen 280 vorgegeben. Wird die Höhe der Einfassungen 280 derart gewählt, das sie größer als das Sensorelement 210 ist, so kann bei einer vollständigen Verfüllung des ersten Bereichs 250 eine definierte Bedeckung des Sensorelements 210 erreicht werden. Die vollständige bzw. maximale Verfüllung des ersten Bereichs 250 kann durch die vorgeschlagene Aufteilung des Gehäuses 200 dadurch sichergestellt sein, das genügend Verfüllungsmaterial 230 in den ersten Bereich eingebracht wird, so dass das Verfüllungsmaterial 230 über die Einfassungen 280 hinweg in Ausgleichsvolumina bzw. den zweiten Bereich fließt. Durch die Höhe der Einfassungen 280 kann somit die Schichtdicke Δ über dem Sensorelement 210 vorgegeben werden.

In einem weiteren Ausführungsbeispiel sind die Einfassungen 280 nicht auf die maximale gewünschte Verfüllungshöhe 240 beschränkt. In diesem Fall befinden sich in den Einfassungen 280 Löcher auf Höhe der maximal gewünschten Verfüllungshöhe, so dass eine Verfüllung des ersten Bereichs bis maximal zu dieser Höhe 240 stattfindet. Neben Löchern könnten jedoch auch örtlich begrenzte Absenkungen in der Einfassung 280 zu einem ähnlichen Effekt führen.

Bei der Verfüllung des Gehäuses 200 bzw. des ersten Bereichs 250 können unterschiedliche Vorgehensweisen gewählt werden. So kann der erste Bereich 250 mit einer vorgegebenen Verfüllungsmenge des Verfüllungsmaterials 230 aufgefüllt werden. Wird die maximale Verfüllungshöhe 240 erreicht, so fließt das überschüssige Verfüllungsmaterials 230 wie in der Figur 2b dargestellt in den angrenzenden zweiten Bereich. Es kann jedoch auch eine Verfüllung gewählt werden, bei der die Verfüllung des ersten Bereichs gestoppt wird, sobald festgestellt wird, dass Verfüllungsmaterial 230 über die Einfassungen hinaus strömt. Weiterhin ist denkbar, die Verfüllung zu stoppen, sobald im zweiten Bereich, das heißt im Bereich 260 und 270 in Figur 2b, eine Mindesthöhe der Verfüllung erreicht ist. Neben einer exakteren Verfüllung des Gehäuses ist durch die vorgestellte Methode jedoch auch eine Einsparung des Verfüllungsmaterials möglich.

Darüber hinaus kann vorgesehen sein, dass neben einem ersten und zweiten Bereich auch ein dritter Bereich im Gehäuse vorgesehen ist. So ist beispielsweise denkbar, dass die Einfassungen des ersten Bereichs unterschiedliche Höhen zu den anderen Bereichen aufweisen. Bei einer Verfüllung des ersten Bereichs ist somit eine wenigstens teilweise Auffüllung beispielsweise eines zweiten Bereich möglich, wohingegen ein dritter Bereich keinerlei Verfüllungsmaterial aufweist. Diese Vorgehensweise hat Vorteile, falls die Bereiche bzw. die in den Bereichen befindlichen Bauelementen unterschiedlich auf die Verfüllung reagieren.

Zusammenfassend sei noch einmal betont, dass bei der heutigen Verfüllung von Gehäusen mit zum Beispiel Gelen oder Passivierungsstoffen auf Grund der Eigenschaften der Materialien, aber auch der unter wirtschaftlichen Gesichtspunkten zu erreichenden Genauigkeiten, eine exakte Vorhersage der Verfüllmenge im Gehäuse nicht möglich ist. Somit kann auch eine Passivierungsanforderung, wie sie regelmäßig bei mikromechanischen Vorrichtungen gefordert wird, nicht sichergestellt werden. Durch die vorliegende Erfindung kann jedoch eine Verfüllung einer mikromechanischen Vorrichtung definiert vorgenommen werden, wobei insbesondere die durch die Verfüllung bedingte Veränderung der Eigenschaften der Sensorelemente konstant gehalten oder gezielt variiert werden können. Dies kann beispielsweise bei der Bedeckung einer Membran mit dem Verfüllungsmaterial zur Erreichung einer gewünschten Steifigkeit genutzt werden. Zur Erzielung einer Veränderung der Eigenschaften (beispielsweise der Messwertaufnahme) des Sensorelements kann es darüber hinaus jedoch ausreichen, nur einen Teil des Sensorelements zu bedecken.

Als Materialien, die sich zur Verfüllung eignen, dienen beispielsweise Silikone/Silikongele, Fluorsilikongele oder Perfluorether. Allgemein sind dabei Materialien verwendbar, die sowohl tixothrop als auch nicht thixothrop sind und sich als Passivierung vor Umwelteinflüssen eignen.

## Patentansprüche

1. Mikromechanische Vorrichtung mit einem Gehäuse (200),
wobei
- das Gehäuse (200) wenigstens
- einen ersten (250) und
- einen zweiten (260, 270)
Bereich aufweist, und
- der erste Bereich (250) des Gehäuses (200) wenigstens
- ein
- elektronisches,
- elektrisches und/oder
- mechanisches
Bauelement (210) und
- eine Einfassung (280) und
- ein Verfüllmaterial (230)
aufweist,
wobei
- der erste Bereich (250) weitestgehend mit dem Verfüllungsmaterial (230) aufgefüllt ist und
- die maximale Verfüllungshöhe (240) des ersten Bereichs durch die Einfassung (280) vorgegeben ist und
- wenigstens ein Teil des Bauelements (210) von dem Verfüllungsmaterial (230) bedeckt ist und
- der zweite Bereich (260, 270)
- kein Verfüllungsmaterial (230) aufweist oder
- wenigstens teilweise mit dem Verfüllungsmaterial (230) aufgefüllt ist.

2. Mikromechanische Vorrichtung nach Anspruch 1, **dadurch gekennzeichnet, dass** die Höhe der Einfassung (280) in Abhängigkeit von der Höhe des wenigstens einen Bauelements (210) vorgegeben ist, wobei insbesondere vorgesehen ist, dass die Höhe der Einfassung (280) wenigstens geringfügig größer als die Höhe des Bauelements (210) ist.

3. Mikromechanische Vorrichtung nach Anspruch 1, **dadurch gekennzeichnet, dass** das Bauelement (210) komplett mit einer Schicht des Verfüllungsmaterials (230) bedeckt ist, wobei insbesondere vorgesehen ist, dass die Schichtdicke (Δ) des Verfüllungsmaterials (230) über dem Bauelement (210) abhängig von der Höhe der Einfassung (280) vorgebbar ist.

4. Mikromechanische Vorrichtung nach Anspruch 1, **dadurch gekennzeichnet, dass** das wenigstens eine Bauelement (210)
- eine Membran, oder
- ein Schwingungskörper, oder
- ein Drehkörper, oder
- ein Widerstand, oder
- ein Temperaturfühler, oder
- ein Dehnungsmessstreifen
repräsentiert,
wobei insbesondere vorgesehen ist, dass das Bauelement (210) ein Sensorelement repräsentiert.

5. Mikromechanische Vorrichtung nach Anspruch 4, **dadurch gekennzeichnet, dass** die Funktion des Sensorelements (210) in Abhängigkeit von der Bedeckung des Sensorelements (210) durch das Verfüllungsmaterial (230) verändert wird,
wobei insbesondere vorgesehen ist, dass die Bedeckung des Sensorelements (210) eine Veränderung der Messwertaufnahme durch das Sensorelement (210) bewirkt.

6. Verfahren zur Herstellung einer mikromechanische Vorrichtung, insbesondere eine Vorrichtung nach einem der Ansprüche 1 bis 5, wobei die mikromechanische Vorrichtung wenigstens ein Gehäuse (200) aufweist,
wobei
- das Gehäuse (200) wenigstens
- einen ersten (250) und
- einen zweiten (260, 270)
Bereich aufweist und
- der erste Bereich (250) des Gehäuses (200) wenigstens
- ein
- elektronisches,
- elektrisches und/oder
- mechanisches
Bauelement (210) und
- eine Einfassung (280) und
- ein Verfüllmaterial (230)
aufweist,
wobei vorgesehen ist, dass der erste Bereich (250) weitestgehend mit dem Verfüllungsmaterial (230) aufgefüllt wird,
wobei
- die maximale Verfüllungshöhe (240) des ersten Bereichs durch die Einfassung (280) vorgebbar ist und
- wenigstens ein Teil des Bauelements (210) von dem Verfüllungsmaterial (230) bedeckt wird und
- die Auffüllung derart stattfindet, dass der zweite Bereich (260, 270)
- kein Verfüllungsmaterial (230) aufweist oder
- wenigstens teilweise mit dem Verfüllungsmaterial (230) aufgefüllt wird.

7. Verfahren nach Anspruch 6, **dadurch gekennzeichnet, dass** die Höhe der Einfassung (280) in Abhängigkeit von der Höhe des wenigstens einen Bauelements (210) vorgegeben wird, wobei insbesondere vorgesehen ist, dass die Höhe der Einfassung (280) wenigstens geringfügig größer als die Höhe des Bauelements (210) ist.

8. Verfahren nach Anspruch 6, **dadurch gekennzeichnet, dass** das Bauelement (210) komplett mit einer Schicht des Verfüllungsmaterials (230) bedeckt wird, wobei insbesondere vorgesehen ist, dass die Schichtdicke (Δ) des Verfüllungsmaterials (230) über dem Bauelement (210) abhängig von der Höhe der Einfassung (280) vorgebbar ist.

9. Verfahren nach Anspruch 6, **dadurch gekennzeichnet, dass** das wenigstens eine Bauelement (210)
- eine Membran, oder
- ein Schwingungskörper, oder
- ein Drehkörper, oder
- ein Widerstand, oder
- ein Temperaturfühler, oder
- ein Dehnungsmessstreifen
repräsentiert,
wobei insbesondere vorgesehen ist, dass das Bauelement (210) ein Sensorelement repräsentiert.

10. Verfahren nach Anspruch 9, **dadurch gekennzeichnet, dass** die Funktion des Sensorelements (210) in Abhängigkeit von der Bedeckung des Sensorelements (210 durch das Verfüllungsmaterial (230) verändert wird,
wobei insbesondere vorgesehen ist, dass die Bedeckung des Sensorelements (210) eine Veränderung der Messwertaufnahme durch das Sensorelement (210) bewirkt.
